# EUROPEAN PATENT APPLICATION

(11) **EP 3 598 639 A1**
(43) Date of publication of application: **22.01.2020**
(21) Application number: 18184775.7
(22) Date of filing: 20.07.2018
(51) Int. Cl.: H03F 3/183, H03F 3/50, H03F 1/32, H03F 3/26, H03F 3/45

(54) **AN AMPLIFIER WITH A SYMMETRIC CURRENT PROFILE**

(71) Applicant: Sonion Nederland B.V., 2132 LS Hoofddorp (NL)
(72) Inventor: Merks-Swolfs, Egon, 2132 LS Hoofddorp (NL); Bosch, Jozef Johannes Gerardus, 2132 LS Hoofddorp (NL)
(74) Representative: Inspicos P/S

(57) **Abstract**

An assembly of an amplifier and a power source, where the current output of the amplifier, for any load, is the same for the same output voltage, irrespective of the sign of the voltage. This symmetry removes the even portions of the distortion.

## Description

The present invention relates to an amplifier suitable for a microphone and in particular to an amplifier which has a symmetric current transfer function.

Many miniature microphones exhibit relatively high output distortion, caused by single-sided (asymmetrical) current clipping, when the required output levels are high and the load impedance is low. These situations can be entitled as "high output current" situations, and they occur when:
a) Load impedance is low,
b) Output amplitude is high (e.g. high SPL or high peak sensitivity) and/or
c) Output signal frequency is high.

The related distortion types are:
- Total Harmonic Distortion (THD)
- Intermodulation Distortion (IMD - also known as Difference Frequency Distortion, DFD)
- DC shift (Demodulation, appears with THD and IMD).

The distortion can increase rapidly in "high output current" situations and become clearly audible, especially for the DC-shift and IMD/DFD. So there is a need to reduce or avoid it.

The invention can be applied to electronic devices in general that need to combine the features of low distortion and low power, such as in microphones, active telecoils and low power sensors.

When used in relation to a microphone, the amplifier may render the microphone insensitive to modulated ultrasound sources (such as proximity sensors), which avoids unpleasant ticking sounds. Also, 2nd order intermodulation distortion may be greatly reduced, which improves the overall sound quality of the microphone. This improved performance may also or alternatively achieve a fixed and pre-determined power consumption under all conditions, meaning that, unlike with class AB amplifiers, the hearing instrument power supply is not stressed at high SPL conditions.

Amplifiers may be seen in: US2014097906, US2015117675, US2015318829, US2017215006, US9743167, EP2097975, EP1475996, EP3014613, EP3026930, and US9398374.

A first aspect of the invention relates to an amplifier with an input, an output and a power connection, the amplifier being capable of:
- receiving from the power connection a current not exceeding a first predetermined current,
- delivering from the output (received from the power connection) a second predetermined maximum current being lower than the first maximum current,
- receiving on the output a current not exceeding a third, predetermined maximum current,
where the second maximum current is between 0.8 and 1.2 times the third maximum current.

It is noted that the different aspects, embodiments and the like of the invention may be combined and that elements of one aspect of the invention may be used in other aspects of the invention.

Amplifiers are described further below.

Usually, the power connection is one or more, usually two, electrical conductors connected to the amplifier and through which the amplifier may be powered. Often, amplifiers are powered by a DC voltage, where a higher voltage is provided on one conductor and a lower, such as ground, is connected to the other connector.

The amplifier is capable of receiving from the power connection a current not exceeding a first predetermined current. This first predetermined current may be a maximum current available from a power source connected to the amplifier or for which the amplifier is suited. Alternatively, this current may be lower than the maximum available current in order to e.g. comply to a power budget for the amplifier.

The amplifier is capable of delivering from the output a second predetermined maximum current being lower than the first maximum current. The current delivered usually is derived from the power connection. This current is lower than the current available to the amplifier. This is usual in that the amplifier may also have an internal consumption. However, as will be described below, other reasons exist for limiting the current behaviour of an amplifier in one direction or both directions.

Finally, the amplifier is capable of receiving on the output a current not exceeding a third, predetermined maximum current, Usually, the current received by an amplifier is dissipated, so this may in principle be as large as desired.

However, the second maximum current is between 0.8 and 1.2 times the third maximum current. Thus, the sinking current of the amplifier, which is usually the largest of the sinking and sourcing currents of an amplifier, is limited. This provides a symmetry in the current behaviour and has advantages both in the power consumption thereof as well as the distortion thereof as described below.

Naturally, the interval of 0.8-1.2 may be reduced as described below.

In one embodiment, the amplifier comprises an amplifier stage connected to the input and the output,
wherein the power connection comprises a first and a second electrical conductor,
where a first limiter connects the first conductor to the amplification stage so as to limit any current flowing from the first conductor to the amplification stage to a first predetermined current.

The amplifier stage may be an amplifier in itself. The amplifier stage may have the above and below capabilities of the amplifiers described.

The limiter may be provided outside of the amplifier and may e.g. be a separate component connected to the amplifier. There are, however, possibilities of building such a limiter into the amplifier and thus providing a more compact element.

A limiter may be implemented in a plurality of manners, such linear or non-linear passive components, active components and the like. A preferred type of limiter is a constant current source which is capable of transmitting a current up to a limit, depending on the voltage across the current source. The circuit may reduce the sensitivity to changes in the power supply voltage, etc. Then, the current source preferably is capable of shutting down (reducing the current transported to 0A or close to 0A) in a smooth manner.

In this manner, the second, maximum current may be defined or set by the first limiter.

In that or another embodiment, the amplifier comprises an amplifier stage connected to the input and the output,
wherein the power connection comprises a first and a second electrical conductor,
where a second limiter connects the second conductor to the amplification stage so as to limit any current flowing from the amplification stage to the second conductor to a second predetermined current.

Clearly, the limiter etc. may be as described, but now the limiter is provided in the current path between the output and the second conductor, which is often connected to or suited for connection to ground.

The use of one or more limiters thus is one manner of arriving at the current limiting scheme of this aspect of the invention.

Another manner may be to, or an addition thereto, is when the amplifier comprises:
- a first amplifier having a first input connected to the input and a first output connected to the output, and
- a second amplifier having a second input connected to the input and a second output connected to the output,
   where the first and second amplifiers are configured so that:
   - the first amplifier is capable of receiving, at the first output, a first, maximum current and of delivering, from the first output, a second current exceeding 1.2 times (up to 10 times) the first, maximum current,
   - the second amplifier is capable of delivering, from the second output, a third, maximum current and of receiving at the second output, a fourth current exceeding 1.2 times the third, maximum current,
   - when current is received by the output, the current received by the first output exceeds the current received by from the second output (by a sufficiently large percentage) and
   - when current is delivered from the output, the current delivered from the second output exceeds the current delivered from the first output (by a sufficiently large percentage).

This parallel coupling of two amplifiers, as well as different amplifier types, is described below, where amplifiers of complementary behaviour are parallel coupled and connected to, such as via a combiner, the amplifier output. The complementary behaviour and the powering thereof, for example, is seen below.

A second aspect of the invention relates to an assembly comprising an amplifier according to the first or any of the below aspects and a load connected to the output. Usually, in use situations, a load will be provided, but often, amplifiers are sold separately. Amplifiers often are, however, adapted to a particular type of load, such as a load impedance, and/or a particular power supply, such as a particular type of battery. Sometimes, an amplifier is also suited for a power or current budget in order to fit in a use scenario.

In one situation, it is desired that the current output from the amplifier is symmetrical not only at the extreme currents but during all of its operation. The current output will depend on the voltage applied on the output but also on the impedance of the load.

In one situation, for each voltage, between 0V and a predetermined maximum voltage, provided on the output, a current fed to the load from the output is between 0.8 and 1.2 times a voltage received by the output when the predetermined maximum voltage, negative, is provided on the output.

Then, the current output will be independent of the sign of the voltage on the output. This type of symmetry has a number of advantages as described below.

In a third aspect, the invention relates to an assembly of a power source and an amplifier having an input and an output, the amplifier being powered by the power source, where
- the power source is configured to output a predetermined maximum voltage and, when outputting the maximum voltage, a maximum current,
- the amplifier is configured to:
   - deliver to the output a first, maximum current being less than 95% of the maximum current, when a voltage provided at the output is the maximum voltage, and
   - receive at the output, when the voltage at the output is the, negative, maximum voltage, a second current being between 0,8 and 1,2 times the first current.

In the present context, the power source may be a battery or other portable power source, such as a solar cell, solar panel, fuel cell, or the like. Naturally, the power source may be or be connected to the grid if desired.

In some embodiments, the power source is attached to the amplifier in a detachable manner, so that the power source may be replaced. In other situations, the power source is permanently attached to the amplifier.

The amplifier has an input and an output. Amplifiers often are capable of receiving a signal, such as a signal varying over time, and output another signal with, preferably, the same time variation but which is amplified. Often, the amplification is a voltage amplification were the voltage output is the input voltage times a gain, which may be any positive number. The gain may be 1 (no amplification), lower than 1 (reduction of voltage) or higher than 1 (increasing voltage). Also, the amplifier may be inverting and thus have a negative gain.

An amplifier normally is not able to correctly handle voltages, received or to be output, which exceed the supply voltage. Thus, if the gain exceeds 1, the amplification desired may not be possible for input voltages higher than the supply voltage divided by the gain. In general, and also when the gain is less than 1, the amplifier may not operate as desired if the voltage input into the amplifier exceeds the supply voltage.

In addition, an amplifier may have internal limitations which further reduce the voltage interval in which it operates as intended (usually meaning a linear gain).

Also, an amplifier may have internal power consumption which limits the voltage interval in which the optimal behaviour is seen. Often, a 10-20% reduction is seen from the supply voltage to the maximum voltage which the amplifier may receive and/or output without reaching a limit.

Thus, the maximum voltage described below need not be the voltage actually supplied by the power supply but rather a, normally above 70%, such as more than 80%, preferably more than 85% thereof, percentage thereof, depending on the amplifier and the gain.

Naturally, the amplifier may have multiple inputs and/or multiple outputs. Differential amplifiers, for example, have multiple inputs. Multiple inputs may be used for feed back circuits or the like configuring the behaviour of the amplifier. Inputs may be combined if desired to obtain less inputs, such as one input. The signal input on one input may be fed to the other input in an amended form, such as negated or filtered if desired. An input or an output of an amplifier usually comprises one or more electrical conductors of the amplifier.

Amplifiers preferably have a fixed gain over all output voltages, but are often limited in a number of manners. Usually, an amplifier is not capable of outputting a voltage higher than a supply voltage thereof. In the present context, the amplifier is fed by the power source which is able to output a predetermined maximum voltage. This maximum voltage may be set or caused by the power source itself, such as the voltage capabilities of a battery.

When outputting the maximum voltage, the power supply is configured to output a maximum current. If a lower voltage is output, the maximum derivable current may be higher, depending on the power source or the amplifier. Naturally, the current supplied may be limited using a limiting circuit. Alternatively, the power supply may by itself be limited in the current which may be supplied to (or received from) the amplifier.

Often, when the assembly takes part in a larger assembly or circuit where the power source supplies also other elements, such as microphones, antennas, sensors, receivers, sound generators, transducers, processors, DSPs, FPGAs, other amplifiers, filters, limiters or the like, a power budget may be provided for the present amplifier. A circuit or limiter may be provided to ensure that the amplifier complies with this power budget. Alternatively, the amplifier may by its operation ensure that this budget is observed.

The amplifier is configured to deliver to the output a first, maximum current being less than 95%, such as less than 90%, such as less than 80%, such as less than 70%, such as less than 60%, such as less than 50%, such as less than 40% of the maximum current, when a voltage provided at the output is the maximum voltage. Thus, the amplifier will not completely deplete the power source so that other elements may be supplied if desired. The actual percentage may be derived from a power budget for the whole product or for the particular power source. In addition, the first, maximum current may still be non negligible, such as at least 10%, such as at least 20%, such as at least 30%, such as at least 40%, such as at least 50%, such as at least 60%, such as at least 70%, such as at least 80% of the maximum current. The lower limit may be depending on a priority or importance of the present assembly compared to other elements powered by the power source.

Usually, amplifiers and/or power sources are able to receive a higher current, at a given voltage, compared to the current which may be supplied. The "sourcing" current is lower than the "sinking" current, usually. Nevertheless, if the sourcing current is too high, it may cause starving of other circuits also powered by the power source. However, when sinking a current, the power is normally dissipated, so sinking will often not cause starving of other circuits.

Thus, as described above, in this situation the amplifier will not be able to completely starve any other elements powered by the power source.

The present amplifier, however, is capable of receiving at the output, when the voltage at the output is the, negative, maximum voltage, a second current being between 0.8 and 1.2 times, such as between 0.9 and 1.1 times, or between 0.8 and 1.1 times, or between 0.9 and 1.2 times, such as between 0.95 and 1.05 times, such as between 0.8 and 1 times, such as between 1 and 1.2 times the first current.

In this context, the negative maximum voltage is the same voltage with the opposite sign. Thus, if the "maximum voltage" is a negative voltage, the "negative, maximum voltage" will be a positive voltage with the same absolute value.

Then, the limitation which the amplifier has in the sourcing direction is "copied" to the sinking direction, or vice versa. This has two advantages:
- A power budget may be observed, as the current limit is present in both sourcing and sinking direction and
- The now more symmetric current transfer behaviour, as described above and further below, reduces certain types of distortion of the signal output of the amplifier.

Thus, one may say that the behaviour of the amplifier at one of the extreme voltages is copied in the other extreme voltage. This is the easiest if the behaviour is copied from the extreme voltage where the current capability (receive or output) is the lowest. Thus, the "worst" behaviour of the amplifier may actually be copied to the other extreme voltage. This may be a reduction of a linearity of the actual current compared to the required current, such as defined by an input voltage into the amplifier, the gain and the parameters of the load. However, a larger degree of symmetry is obtained, as will be described below.

A large number of manners exist of obtaining an amplifier with the above behaviour. Many amplifiers have therein different types of limitations, such as bias voltages and the like, which may be set to obtain a particular behaviour. Also or alternatively external elements may be used if desired. The amplifier of the first and third aspects is especially well suited for this, as it has internal current limiters limiting the current in the two directions.

In one embodiment, the assembly further comprises a limiter configured to limit the current received at the output, when the voltage at the output is the, negative, maximum voltage, to the second current. This limiter may simply monitor and adapt the current output of the amplifier output, for example, or the current fed to the amplifier output if desired. Also, an adaption of the signal into the amplifier may be performed to thereby adapt the output of the amplifier.

In another embodiment, the amplifier comprises:
- a first amplifier having a first input and a first output and being configured to:
   - deliver to the first output a first, maximum current being less than 95% of the maximum current, when a voltage provided at the first output is the maximum voltage, and
   - receive at the first output, when the voltage at the first output is the, negative, maximum voltage, a second current exceeding 1,2 times the first current and
- a second amplifier having a second input, connected to the first input, and a second output, the second amplifier being configured to:
   - receive at the second output a third, maximum current being less than 95% of the maximum current, when a voltage provided at the second output is the, negative, maximum voltage, and
   - deliver to the second output, when the voltage at the second output is the maximum voltage, a fourth current exceeding 1,2 times the third current, and
- a combiner connecting the first and second outputs to the output.

Then, two amplifiers with similar, but inverse or opposite behaviour at the extreme voltages may be combined.

Clearly, the combiner may be a galvanic combiner or a combiner with passive elements adding the two output signals to each other. A simple combiner may be a resistor allowing the two amplifiers to output slightly different voltages.

If the outputs of both amplifiers are fed, via or by the combiner, to the output, it is seen that the output will have symmetric properties, as the "good" behaviour of one amplifier is combined with the "bad" behaviour of the other - at both of the extreme voltages.

Preferably, the current output is the same (apart from the direction of the current) at each output voltage (the positive and negative sign thereof), so that a symmetry is seen over all of the voltage range at which the amplifier can operate. The voltage, or at least the desired voltage, usually is defined by the voltage input and the gain of the amplifier, whereas the current then is defined by a load connected to the amplifier output - but also by the capabilities of the amplifier.

Often, the assembly further comprises a load connected to the output, where the assembly is configured to control the current delivered from and received by the output so that for each first voltage between 0V and the maximum voltage:
- when the first voltage is provided at the output, a third current is delivered from or sourced from the output to the load,
- when the first voltage, negative, is provided at the output, a fourth current is received by or sinked by the output from the load,
where, for each first voltage, the corresponding third current is between 0,8 and 1,2 times the fourth voltage for that first voltage.

Then, the symmetry is also seen for voltages between the two extreme voltages. The current may vary relative to the voltage, and especially when the load has a low impedance, as the amplifier may then be current limited. Then, due to Ohms law, the current desired may be higher than that which can be supplied. Then, the desired current will deviate from the actual current, but the actual current output will still be symmetric around 0V. As will be described below, this symmetry will reduce certain types of distortion, as the Taylor expansion of a transfer function whose amplitude is symmetrically limited, only has odd order components.

As described below, this symmetry will reduce both the distortion and the DC shift. The latter DC shifts cause irritating clicking sounds when the amplifier does not function optimally. Thus, the load may have an impedance causing the current to be at least 50%, such as at least 75%, such as at least 95%, such as 100% of the maximum current at at least some first voltages. Thus, the load may have a sufficiently low resistance or impedance, at least at some frequencies, to require a sufficiently high current.

Very high impedance loads will often not require a current in the range where the amplifier will reach the non-linear and limiting stages. It is when connected to a low impedance load - or a load which may have a low impedance in particular situations - that the well-behaved assembly of these aspects is particularly advantageous.

A load may be a filter, such as an RC filter. When the load comprises a capacitor, the load impedance may be frequency dependent, where the impedance may be low at higher frequencies. Then, the current may depend on the frequency, so that the assembly may be dimensioned for a maximum frequency.

A situation which may be problematic in legacy assemblies, such as in hearing aids, is a situation where ultrasound is present. Ultrasound is e.g. used for proximity sensors for automatic doors. This high frequency will cause an RC filter to have a very low impedance which again will drive the legacy assembly into current limitation, causing distortion.

So,
- If a microphone has a symmetrical current transfer function, it does not generate even harmonics, IMD d2 and DC shifts at high current situations.
- Additionally, the supply current of an amplifier buffer utilizing such transfer function is fixed and cannot exceed a certain value at "high output current" conditions.

A fourth aspect of the invention relates to an assembly of a power source, an amplifier having an input and an output and a load connected to the output, the amplifier being powered by the power source, where
- the power source is configured to output or receive a maximum current,
- the amplifier is configured to:
   - deliver to the load a first, maximum current being less than 95% of the maximum current, when a threshold voltage is provided at the output, and
   - receive at the output, when the voltage at the output is the, negative, threshold voltage, a second current being between 0.8 and 1.2 times the first current.

Clearly, the assembly of the fourth aspect may be combined with that of the first or third aspects. A load may be connected to the assembly of the third aspect to arrive at an assembly according to the fourth aspect.

Thus, the amplifier and power source may be as those described in relation to the first and third aspects.

The load may be permanently or intermittently attached to the amplifier if desired.

The threshold voltage may be the maximum voltage which may be supplied by the power source, the maximum voltage which may be output or received by the amplifier, or another voltage which may be selected, set or defined in or by elements of the assembly, such as any circuit or element receiving the output of the amplifier or an element connected to feed a signal to the amplifier input.

The maximum current of the power source may, as above, be the lowest of 1) the maximum current the power source is able to output and 2) the maximum current the power source is able to receive. The two maximum currents (1) and 2)) may be different.

As mentioned above, a power budget may be complied to, so that the current delivered/received by the amplifier is lower than the current which may be handled by the power source. This limit may be set by external circuits or elements or directly by the amplifier.

Again, the current delivered/received (sourced/sinked) will be relatively identical at the positive and negative threshold voltage, so that the advantages described above are obtained. Naturally, the more narrow intervals described above are equally applicable in relation to this aspect of the invention.

In general, it is simple to test whether an assembly has the above advantages, if a load with a sufficiently low impedance is provided. Legacy amplifiers/power supplies will then have a higher current in one direction than in the other, when the amplifier has a sufficiently high output voltage (negative or positive). In usual legacy amplifiers, the output voltage is at its maximum possible value, the current in the two situations will differ by more than 20%. Also, the maximum voltage in one direction (either positive or negative) may be found by feeding the maximum current in one direction into to the load. Then, the output voltage will be the maximum obtainable voltage with that sign. This test may be performed with the current in both directions, whereby the maximum obtainable voltage is obtained with both signs.

Then, in one embodiment, the voltage sign is identified which may provide the highest current, and the current output in that direction is then limited.

As described above, a large number of manners exist of limiting the current, one being where the assembly comprises a limiter configured to limit the current delivered by or received by the output, when the voltage at the output is the, negative, threshold voltage, to the second current.

In another situation, as is also described above, the amplifier may comprise:
- a first amplifier having a first input and a first output and being configured to:
   - deliver to the first output a first, maximum current being less than 95% of the maximum current, when a voltage provided at the first output is the threshold voltage, and
   - receive at the first output, when the voltage at the first output is the, negative, threshold voltage, a second current exceeding 1,2 times the first current and
- a second amplifier having a second input, connected to the first input, and a second output, the second amplifier being configured to:
   - receive at the second output a third, maximum current being less than 95% of the maximum current, when a voltage provided at the second output is the, negative, threshold voltage, and
   - deliver to the second output, when the voltage at the second output is the threshold voltage, a fourth current exceeding 1,2 times the third current, and
- a combiner connecting the first and second outputs to the output.

In an especially interesting embodiment, a symmetry is seen over all of the voltage span of the amplifier, such as, as is also described above, were the assembly is configured to control the current sourced by and sinked by the output so that for each first voltage between 0V and the threshold voltage:
- when the first voltage is provided at the output, a third current is sourced from the output to the load,
- when the first voltage, negative, is provided at the output, a fourth current is sinked by the output from the load,
where, for each first voltage, the corresponding third current is between 0,8 and 1,2 times the fourth current for that first voltage.

In the following, preferred embodiments will be described with reference to the drawing, wherein:
- Figure 1 illustrates the Current Transfer Function for: Non-symmetrical current transfer (left) and symmetrical current transfer (right).
- Figure 2 illustrates the transfer flow from required input current (single frequency; left) to delivered output current (and its frequency components) in case of a non-symmetrical transfer function (top) and symmetrical transfer function (bottom).
- Figure 3 illustrates the Output Distortion of the situation illustrated in figure 2: THD (left axis) and DC-level (right axis) as function of required output current relative to the maximum output current for the non-symmetric transfer (solid lines) and the symmetric transfer (dashed lines).
- Figure 4 illustrates the transfer flow from required input current (dual frequency; left) to delivered output current (and its frequency components) in case of a non-symmetrical transfer function (top) and symmetrical transfer function (bottom).
- Figure 5 illustrates the Output Distortion of the situation illustrated in figure 4: IMD d2 (left axis) and IMD d3 (right axis) as function of required output current relative to the maximum output current for the non-symmetric transfer (solid lines) and the symmetric transfer (dashed lines).
- Figure 6 illustrates a block diagram of an assembly according to the invention,
- Figure 7 illustrates an ideal circuit of a second embodiment of the invention.
- Figure 8 illustrates an ideal circuit of a third embodiment with a current mirror.
- Figure 9 illustrates a preferred type of amplifier according to an aspect of the invention,
- Figure 10 illustrates another type of amplifier for use in aspects of the invention,
- Figure 11 illustrates an amplifier which is sourcing current limited,
- Figure 12 illustrates an amplifier which is sinking current limited,
- Figure 13 illustrates another embodiment of an amplifier according to the invention,
- Figure 14 illustrates another embodiment of an amplifier according to the invention,
- Figure 15 illustrates another embodiment of an amplifier according to the invention, and
- Figure 16 illustrates another embodiment of an amplifier according to the invention.

To explore the properties of distorted signals, the total transfer function is described by its Taylor expansion, and when doing so, it is known from textbook theory that nonlinear distortion is generated by the 2nd and higher order components:
- The even order components (i.e. 2, 4 ,...) create even harmonics, IMD d2 (difference frequency demodulation) and DC components.
- The odd order components (i.e 3 ,5 ,...) create odd harmonics and IMD d3.

In comparison, the Taylor expansion of a linear function has only 0 and first order components. Linear functions do not create distortion.

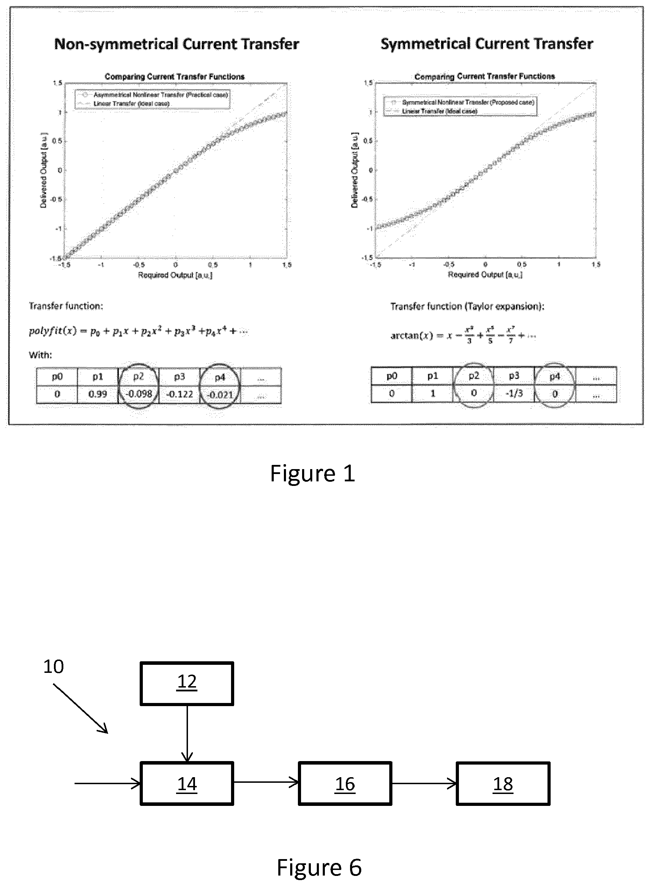

To prove the principle, referring to figure 1, of a symmetrical and limiting current transfer function, and its properties of low non-linear distortion, a simulation study was done. With this study the nonlinearly of a symmetrical transfer function (taken as the arctangent of the required output current) was compared to that of an asymmetrical transfer function. The asymmetrical transfer function was defined as the arctangent of the required output current for positive (sourcing) currents and presumed linear for negative (sinking) currents. Full descriptions of the transfer functions, including the Taylor and polynomial expansions are given in figure 1.

Note the zero values for the even order components in the case of the symmetrical transfer function, whereas the non-symmetrical transfer function has non-zero values for all odd higher order components.

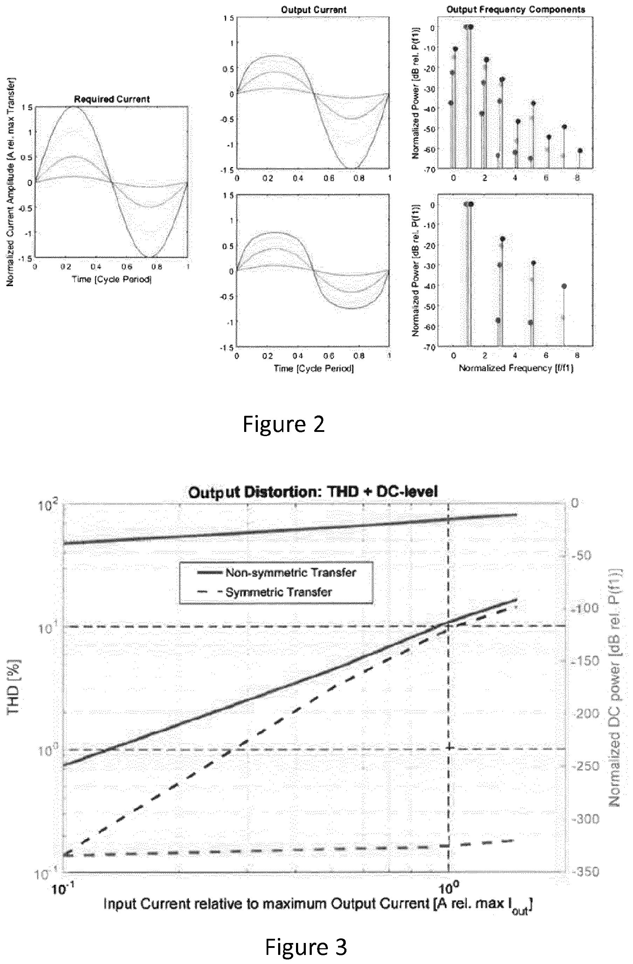

Using the given transfer functions (see figure 2):
- THD performance was evaluated by applying a Gaussian modulated sinewave burst at different relative amplitudes, i.e. 10%, 50%, 100% and 150%, with respect to the maximum output current.
- IMD performance was evaluated by applying a Gaussian modulated sinewave burst, containing 2 sinewaves with a difference frequency of 1 kHz, again at different relative amplitudes, i.e. 10%, 50%, 100% and 150%, with respect to the maximum output current

The simulated flow from required input current, with single frequency content, to the transferred output current and its frequency components, are given in Figure 2. Figure 3 shows the THD and DC-levels as function of required current.

Clearly:
- The symmetric transfer function has initially 10x lower THD than the non-symmetric transfer. Both converge at relative input amplitudes >150%
- The symmetric transfer function generates virtually no DC (the plotted values <-300 dB are numerical limits), whereas significant DC shifts are generated by the non-symmetric transfer.

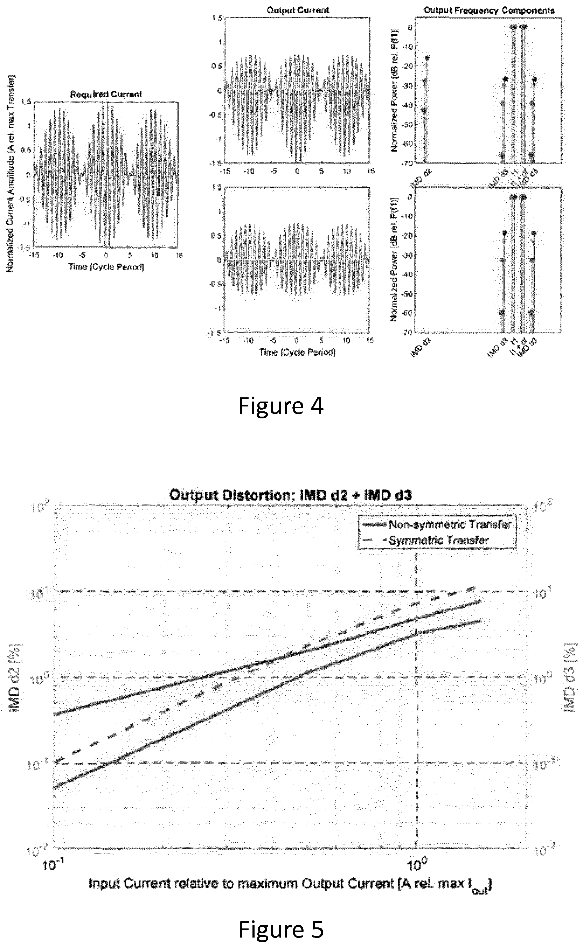

Performing the same simulation but with dual frequency content, to the transferred output current and its frequency components, the results are given in Figure 4. Figure 5 now shows the IMD d2 and the IMD d3 -levels as function of required current.

From these figures we see that for:
- IMD d2: The symmetric transfer function generates virtually no IMD d2 (values several orders below plotting range), whereas significant IMD d2 is generated by the non-symmetric transfer.
- IMD d3: In this case, the symmetric transfer function generates about 2 times more IMD d3 than the non-symmetric case, and crosses the IMD d2 line of the non-symmetric transfer function at 40% input level.

Thus:
- A symmetrical current transfer avoids the generation of DC shifts and even order harmonic (THD) and intermodulation distortion (IMD d2).
- With respect to non-symmetric transfer functions, the symmetrical transfer function does have higher odd order distortion components, i.e. odd order THD and IMD d3.

The present invention is well suited for low power situations, such as in hearing aids, hearables, battery powered sensors and the like, such as with a maximum power supply voltage of 0.9V or less and a maximum power supply current of 100µA, where a low power consumption is essential.

Usually, the assembly of the amplifier and limiter will compete over the available power with other elements, such as transducers, receivers, microphones, processors, sensors, DSPs and the like, so that it is desired that the assembly actually uses less power than what is really available from the power source - in order to allow the power source to also power the other elements. Often, a power budget is drafted for the individual elements, including the amplifier, which in this connection then also has the limiter.

Often, an amplifier is configured to output a voltage up to its supply voltage, so that any power limitation may be to the current supplied.

Also, amplifiers inherently have a maximum current delivery/sourcing capability, so that there is a limit to the current which may be delivered from the amplifier output to a load. Conversely, often there is no real limit to the current which may be received by the amplifier from the output. Hence the lack of symmetry in the current transfer graphs.

Amplifiers do exist, though, which have the inverse situation, where the limitation is in the receiving direction.

In figure 6, a block diagram of an assembly 10 of a power source 12, an amplifier 14, a limiter 16 and a load 18 is seen. The power source 12 may be connected to a number of other elements, such as a microphone which may supply the signal for the amplifier and/or a processor for controlling the assembly.

Clearly, the limiter may be positioned in other positions or even comprised in the amplifier.

The operation of a standard amplifier is to have a gain, which preferably is constant but which may be voltage dependent (the voltage to be output) or frequency dependent.

Often, amplifiers are linear at least around 0A output current, but this linearity will become more pronounced at high currents, which again will be seen at low load impedances. Loads may be purely resistive but often comprise filters which may get a low impedance in certain situations. If the load is capacitive, very high frequencies may reduce the overall impedance drastically, such as if the microphone picks up ultrasound, which is used by e.g. some proximity sensors. In that situation, the current limiting is desired in order to e.g. not deplete the power source to a degree where other system components are starved.

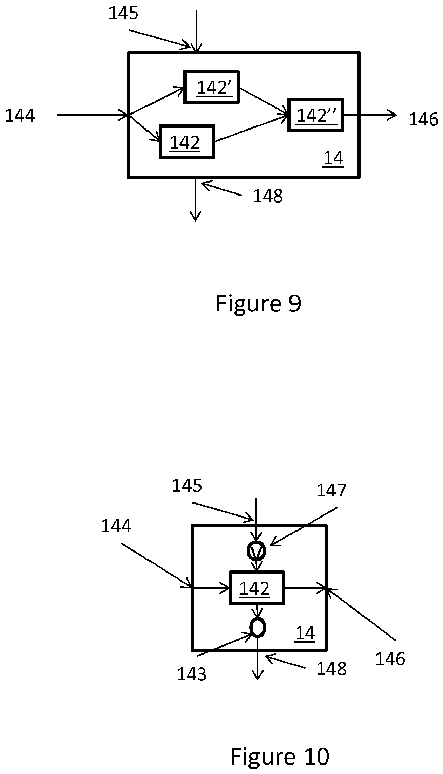

In one embodiment, as is illustrated in figure 9, the amplifier 14 may comprise two amplifiers, 142 and 142' which are both connected to the power supply conductors 145 and 148. The arrows of the conductors illustrate a direction of current flowing from a higher voltage connected at 145 to a lower voltage, such as ground, connected to 148. Naturally, this is a design choice, and other voltages and another direction of the current may be selected.

The amplifiers 142/142' are both connected to the input 144 and to a combiner 142", which combines the output of the amplifiers 142/142' and output the combined result on the output 146.

The amplifiers 142/142' have inverted characteristics so that the amplifier 142 is current limited when the output signal requires current to be fed from the output 146, such as when a voltage of the output signal is positive. Thus, the amplifier 142 is configured to output, at a given voltage, such as a maximum obtainable output voltage, a first current, whereas it is able to receive a second, higher current, when the output voltage is negative.

Conversely to that, the amplifier 142' is current limited when the output signal requires current to be received from the output 146, such as when a voltage of the output signal is negative. Thus, the amplifier 142' is configured to receive, at a given voltage, such as a maximum obtainable output voltage, a third current, whereas it is able to output a fourth, higher current, when the output voltage is positive.

The combiner may be left out or be formed by a galvanic connection of the outputs of the amplifiers 142/142'. Alternatively, the combiner may combine the two output signals in any desired manner. One signal may be amplified further, attenuated, filtered or the like if desired.

When combining the output of the two amplifiers, the combined output will be the sum of the first and fourth currents and the sum of the second and third currents. Thus, the amplifiers may be selected or paired so that these sums give the sought after symmetry. Clearly, the maximum currents of the amplifiers may be different, as long as the combination gives the desired overall current behaviour.

The combiner may additionally perform a smooth transition from when the output from only one amplifier is connected to the output to when the output of only the other amplifier is connected to the output. The switching/transition may simply be controlled by the sign of the voltage output from the output, as this identifies the direction of the current on the output 146. Again, the amplifiers or their characteristics may be selected to arrive at the sought after symmetry.

In general, the amplifiers 142/142' may be based on the same technology or different technologies.

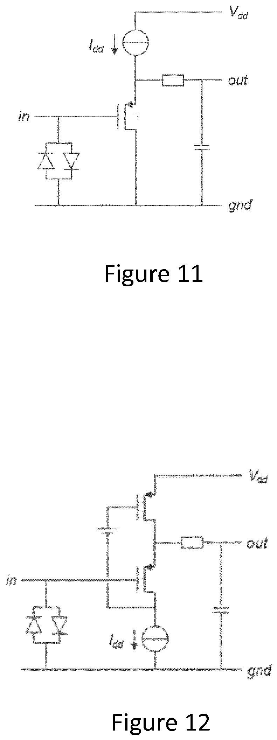

In figure 11, an amplifier is illustrated which is limited in the current delivered to the output, due to the limitation of the current source Idd, but not in the current received from the output, which current may be fed directly to ground.

In figure 12, on the other hand, an amplifier is illustrated which, due to the current limiter Idd, is limited in the current which may be received on the output, whereas the current output from the output may be derived directly with no limit from the Vdd supply.

In figure 10, an interesting type of amplifier is illustrated which has an amplifier or amplifier stage 142 connected to the input 144, the output 146 as well as the power supply conductors 145/148. In this embodiment, however, limiters 143/147 are provided between the power supply conductors and the amplifier power inputs. Thus, the current drawn from the supply 145 for delivery on the output is limited or controlled by the limiter 147, whereas the current received on the output to be delivered to the supply 148 is limited or controlled by the limiter 143. Then, the limiters may be selected or controlled to have the desired behaviour, such as the above symmetric current behaviour.

In this context, the settings of the limiters may be adapted for a number of purposes. In one example, it is noted that the current supplied via the limiter 147 may be supplied to the amplifier 142 even though the output voltage is negative and a current is also received on the output. Then, the limiter 143 should be set to accept both currents in the situation where the only current path from the amplifier is through the limiter 143.

In general, different types of limiters exist. Limiters may be provided by passive components, active components, a mix thereof, as well as more complex circuits. A simple type of limiter is a constant current source. A constant current source will limit the current through it to its maximum current. Often, constant current sources are able to actually reduce the current transported there through, such as based on a voltage over the current source.

As described above in relation to figure 1, it may be desired to have the current limited behaviour for both output current directions/polarities. Thus, if the amplifier 14 is current limited in its current which may be output from the output, it may also be, preferably similarly, limited in the current which may be received from the output.

Naturally, the amplifier 142 may receive power from several conductors 145. I that respect, multiple limiters 147 may be provided with a summed characteristic as desired.

Also, multiple sink conductors 148 may be provided, again with one or more limiters 143, the operation again may be combined to arrive at the desired operation.

Clearly, the amplifier 142, in the figure 10 context, may be any type of amplifier or amplifier stage, such as a class A amplifier, class B amplifier, or a class AB amplifier.

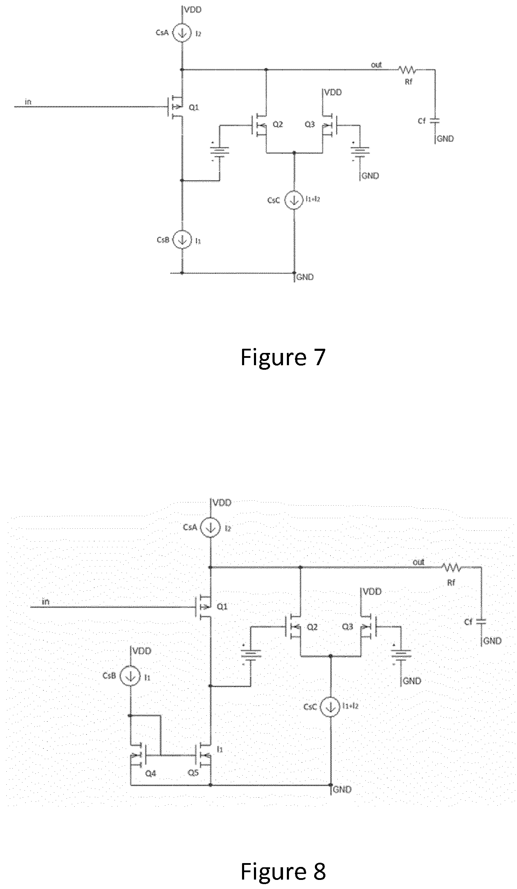

A simplified schematic of yet another embodiment is shown in figure 7. The resulting configuration consists of 2 basic circuit elements that are combined in a non-standard way to combine the functional requirements of high-quality linear amplification and symmetrical current limiting in current overload situations.

A linear amplifier is defined by the left transistors Q1 and Q2 in the circuit of figure 7, where they form a 2-stage amplifier with a unity gain feedback loop. Any gain may be selected.

This linear amplifier receives a positive voltage Vdd via a limiter CsA and it feeds current to Ground via two limiters CsB and CsC.

In this embodiment, the limiters are implemented as current sources which are capable of transferring a maximum current, 12, I1 and I1+I2, respectively.

The symmetrical current limiting is provided by adding the right transistor Q3 that, together with transistor Q2, forms a differential pair. Differential pairs are known for their symmetrical limiting properties.

Considering the overload properties of this circuit:
- When the input voltage V-in rises, the output voltage V-out also rises. Ultimately, Q1, Q2 and also current source CsB (I1) switch off. Maximum current sourced by the output to its load (filter Rf/Cf) is then 12. In that case, the 'overflow' transistor Q3 carries I1+I2.
- When the input voltage V-in decreases, the output voltage V-out also decreases. Ultimately, Q1 and Q2 become completely conductive, carrying I1 in Q1 and I1+I2 in Q2. Maximum current sinked by the output from its load (filter Rf/Cf) is then 2*I1. The 'overflow' transistor Q3 is switched off in that case.

The output current will be limited symmetrically when the Bias currents scale: I2=2*I1.

In addition, it is preferred that the Current source CsB (carrying I1) is able to shut down in a controlled way, without introducing new asymmetry (e.g. quick, with a small 'linear-region').

Noticeable elements in this circuit are:
- To use a differential pair as an output stage of an amplifier is rather unusual, as their properties usually make them suitable as input stage.
- During current sinking phase, the maximum sinking current (2xI1) is evenly distributed between input transistor Q1 and output transistor Q2, so that, as a result, both transistors carry different currents (I1 and I1+I2, respectively). Thus, internal asymmetry of the current levels may be desired in order to achieve the overall symmetry sought for.
- When adding gain to this circuit, it should be considered that part of the output current may need to flow through feedback resistors.

The current sources carrying I1, I2 and I1+I2 preferably are balanced to get the desired symmetrical behaviour for current sourcing and current sinking.

Furthermore, as mentioned above, the current source CsB (carrying I1) preferably is able to shut down in a controlled way. This can e.g. be achieved by adding a simple current mirror in the form of Q4 and Q5, which are designed for small 'linear region' (see Figure 8).

This also has the advantage that it is easier to provide a current source from Vdd than at a voltage close to Ground.

The current mirror will have the same overall functionality as the current source CsB in figure 7.

Shutting CsB down in a controlled manner, such as slowly and not abruptly, if a current limit is reached, will allow for the sinking behaviour to simulate the softer behaviour of the sourcing.

In one embodiment, the source carrying drive currents I1 and I2 is scalable, allowing for range switching between low- and high current applications. With this addition, alternative trade-off decisions can be made between total distortion and current consumption, without the penalty of adding DC-shifts or IMD-D2. This also counts for lower currents.

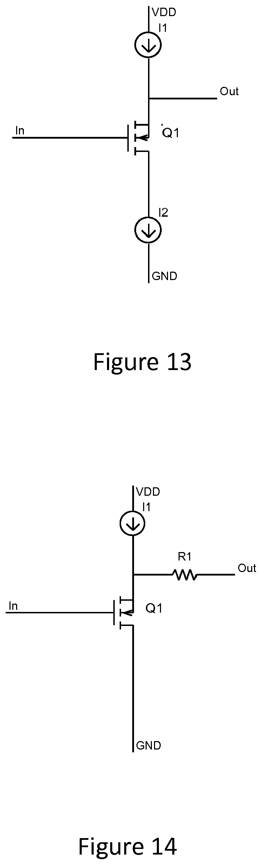

Figure 13 illustrates yet another embodiment of an amplifier in the form of a source follower (Q1) in between 2 matched biasing current sources, I1 and 12. The symmetry and current limits are guaranteed by I1 and 12.

Figure 14 illustrates another embodiment of an amplifier in the form of a source follower (Q1) with a biasing current source I1 and a separate symmetrical current limiting function block (e.g. a resistor) at the output node. The current is reduced in the sourcing phase.

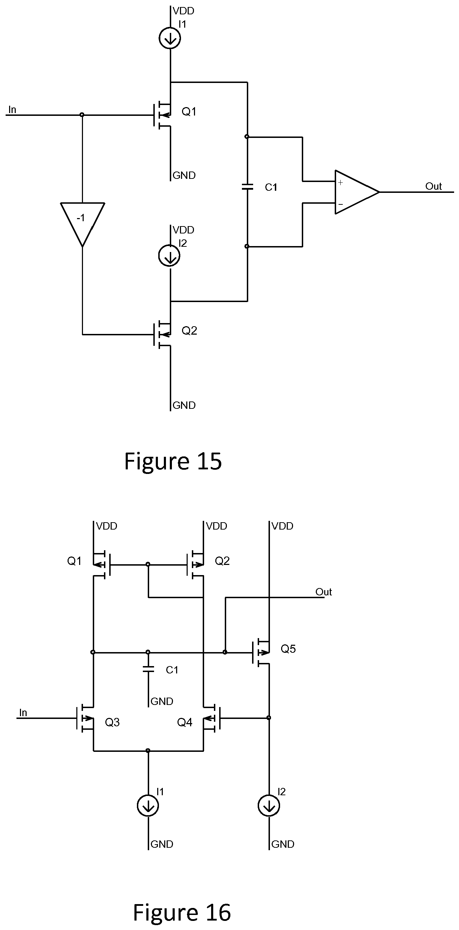

Figure 15 illustrates an amplifier as an assembly of two source followers (Q 1 and Q2) with 1 inverted input to create a differential low-pass filtered (LPF) signal, such as is achieved with an RC-filter, with a common mode DC at the 2^{nd} stage. Bias current sources I1 and I2 are matched such that Q1 and Q2 operate at the same biasing level. Each source follower on its own has a non-symmetric current transfer with limited sourcing current and unlimited sinking current. Because of the interconnected outputs, Q1 will limit the current while sourcing the positive portions of the input signal, while, because of the inverting block, Q2 will limit the current while sourcing the negative portion of the input signal. Because the sinking current of Q1 will be limited by the current sourcing of Q2 and vice versa, the combined current transfer will be limited and symmetrical.

Figure 16 illustrates an amplifier comprising a differential pair, a current mirror and feedback.

Transistors Q3 and Q4 form a differential pair of which Q3 forms a dual-stage feedback amplifier with Q5, whose output signal is fed back to the gate of Q4. The signal current that is processed by current mirror Q1 and Q2 is filtered in the current domain by filtering capacitor C1. The output signal is read inside the feedback loop at the gate of Q5.

In this manner, frequency filtering in the current domain could give steeper filter curves if desired.

## Claims

1. An amplifier with an input, an output and a power connection, the amplifier being capable of:
- receiving from the power connection a current not exceeding a first predetermined current,
- delivering from the output a second predetermined maximum current being lower than the first maximum current,
- receiving on the output a current not exceeding a third, predetermined maximum current,
where the second maximum current is between 0.8 and 1.2 times the third maximum current.

2. An amplifier according to claim 1, comprising an amplifier stage connected to the input and the output,
wherein the power connection comprises a first and a second electrical conductor,
where a first limiter connects the first conductor to the amplification stage so as to limit any current flowing from the first conductor to the amplification stage to a first predetermined current.

3. An amplifier according to claim 1 or 2, comprising an amplifier stage connected to the input and the output,
wherein the power connection comprises a first and a second electrical conductor,
where a second limiter connects the second conductor to the amplification stage so as to limit any current flowing from the amplification stage to the second conductor to a second predetermined current.

4. An amplifier according to any of the preceding claims, the amplifier comprising:
- a first amplifier having a first input connected to the input and a first output connected to the output, and
- a second amplifier having a second input connected to the input and a second output connected to the output,
where the first and second amplifiers are configured so that:
- the first amplifier is capable of receiving, at the first output, a first, maximum current and of delivering, from the first output, a second current exceeding 1.2 times the first, maximum current,
- the second amplifier is capable of delivering, from the second output, a third, maximum current and of receiving at the second output, a fourth current exceeding 1.2 times the third, maximum current,
- when current is received by the output, the current received by the first output exceeds the current received by from the second output and
- when current is delivered from the output, the current delivered from the second output exceeds the current delivered from the first output.

5. An assembly comprising an amplifier according to any of the proceeding claims and a load connected to the output.

6. An assembly according to claim 5, wherein, for each voltage, between 0V and a predetermined maximum voltage, provided on the output, a current fed to the load from the output is between 0.8 and 1.2 times a voltage received by the output when the predetermined maximum voltage, negative, is provided on the output.

7. An assembly of a power source and an amplifier having an input and an output, the amplifier being powered by the power source, where
- the power source is configured to output a predetermined maximum voltage and, when outputting the maximum voltage, a maximum current,
- the amplifier is configured to:
- deliver to the output a first, maximum current being less than 95% of the maximum current, when a voltage provided at the output is the maximum voltage, and
- receive at the output, when the voltage at the output is the, negative, maximum voltage, a second current being between 0.8 and 1.2 times the first current.

8. An assembly according to claim 7, further comprising a limiter configured to limit the current drained to/by the output, when the voltage at the output is the, negative, maximum voltage, to the second current.

9. An assembly according to claim 7, wherein the amplifier comprises:
- a first amplifier having a first input and a first output and being configured to:
- deliver to the first output a first, maximum current being less than 95% of the maximum current, when a voltage provided at the first output is the maximum voltage, and
- receive at the first output, when the voltage at the first output is the, negative, maximum voltage, a second current exceeding 1,2 times the first current and
- a second amplifier having a second input, connected to the first input, and a second output, the second amplifier being configured to:
- receive at the second output a third, maximum current being less than 95% of the maximum current, when a voltage provided at the second output is the, negative, maximum voltage, and
- deliver to the second output, when the voltage at the second output is the maximum voltage, a fourth current exceeding 1,2 times the third current, and
- a combiner connecting the first and second outputs to the output.

10. An assembly according to any of claims 1-3, further comprising a load connected to the output, where the assembly is configured to control the current sourced by and sinked by the output so that for each first voltage between 0V and the maximum voltage:
- when the first voltage is provided at the output, a third current is sourced from the output to the load,
- when the first voltage, negative, is provided at the output, a fourth current is sinked by the output from the load,
where, for each first voltage, the corresponding third current is between 0,8 and 1,2 times the fourth current for that first voltage.

11. An assembly of a power source, a load and an amplifier having an input and an output, the amplifier being powered by the power source, where
- the power source is configured to output or receive a maximum current,
- the amplifier is configured to:
- deliver to the load a first, maximum current being less than 95% of the maximum current, when a threshold voltage is provided at the output, and
- receive at the output, when the voltage at the output is the, negative, threshold voltage, a second current being between 0.8 and 1.2 times the first current.

12. An assembly according to claim 11, further comprising a limiter configured to limit the current drained to/by the output, when the voltage at the output is the, negative, threshold voltage, to the second current.

13. An assembly according to claim 11, wherein the amplifier comprises:
- a first amplifier having a first input and a first output and being configured to:
- deliver to the first output a first, maximum current being less than 95% of the maximum current, when a voltage provided at the first output is the threshold voltage, and
- receive at the first output, when the voltage at the first output is the, negative, threshold voltage, a second current exceeding 1,2 times the first current and
- a second amplifier having a second input, connected to the first input, and a second output, the second amplifier being configured to:
- receive at the second output a third, maximum current being less than 95% of the maximum current, when a voltage provided at the second output is the, negative, threshold voltage, and
- deliver to the second output, when the voltage at the second output is the threshold voltage, a fourth current exceeding 1,2 times the third current, and
- a combiner connecting the first and second outputs to the output.

14. An assembly according to any of claims 11-13, where the assembly is configured to control the current sourced by and sinked by the output so that for each first voltage between 0V and the threshold voltage:
- when the first voltage is provided at the output, a third current is sourced from the output to the load,
- when the first voltage, negative, is provided at the output, a fourth current is sinked by the output from the load,
where, for each first voltage, the corresponding third current is between 0,8 and 1,2 times the fourth current for that first voltage.
